# EUROPÄISCHE PATENTSCHRIFT

(11) **EP 0 856 198 B1**
(45) Veröffentlichungstag und Bekanntmachung des Hinweises auf die Patenterteilung: **02.01.2002**
(21) Anmeldenummer: 96934617.0
(22) Anmeldetag: 10.10.1996
(51) Int. Cl.: H01L 23/13, H01L 23/66

(54) **POLYMERES HÖCKER-MATRIX-GEHÄUSE FÜR MIKROWELLEN-SCHALTUNGSANORDNUNGEN**
POLYMER STUD-MATRIX HOUSING FOR MICROWAVE CIRCUIT ARRANGEMENTS
BOITIER DE MATRICE A BOSSAGE POLYMERE POUR CIRCUITS A MICRO-ONDES

(30) Priorität: 16.10.1995 DE 19538465
(43) Veröffentlichungstag der Anmeldung: 05.08.1998
(73) Patentinhaber: SIEMENS N.V., 1060 Bruxelles (BE); INTERUNIVERSITAIRE MICROELEKTRONICA CENTRUM VZW, 3001 Leuven (BE)
(72) Erfinder: DUMOULIN, Ann, B-8210 Zedelgem (BE); HEERMAN, Marcel, B-9200 Merelbeke (BE); ROGGEN, Jean, B-3560 Lummen (BE); BEYNE, Eric, B-3001 Leuven (BE); VAN HOOF, Rita, B-3191 Boortmeerbeek (BE)
(74) Vertreter: Zedlitz, Peter, Dipl.-Inf.
(86) Internationale Anmeldenummer: EP9604404
(87) Internationale Veröffentlichungsnummer: WO9715077

(56) Entgegenhaltungen:
- EP-A- 0 617 466
- EP-A- 0 645 953
- WO-A-89/00346
- WO-A-89/10005
- WO-A-92/02040
- WO-A-96/03020
- WO-A-96/09646
- US-A- 3 271 507
- US-A- 3 483 308
- US-A- 5 081 520

## Beschreibung

Integrierte Schaltkreise bekommen immer höhere Anschlußzahlen und werden dabei immer weiter miniaturisiert. Die bei dieser zunehmenden Miniaturisierung erwarteten Schwierigkeiten mit Lotpastenauftrag und Bestückung, sollen durch neue Gehäuseformen behoben werden, wobei hier insbesondere Single- Few- oder Multi-Chip-Module im Ball Grid Array Package hervorzuheben sind (DE-Z productronic 5, 1994, Seiten 54, 55). Diese Module basieren auf einem durchkontaktierten Substrat, auf welchem die Chips beispielsweise über Kontaktierdrähte oder mittels Flipchip-Montage kontaktiert sind. An der Unterseite des Substrats befindet sich das Ball Grid Array (BGA), das häufig auch als Solder Grid Array, Land Grid Array oder Solder Bump Array, bezeichnet wird. Das Ball Grid Array umfaßt auf der Unterseite des Substrats flächig angeordnete Lothöcker, die eine Oberflächenmontage auf den Leiterplatten oder Baugruppen ermöglichen. Durch die flächige Anordnung der Lothöcker, können hohe Anschlußzahlen in einem groben Raster von beispielsweise 1,27 mm realisiert werden.

Bei der sogenannten MID Technologie (MID = Moulded Interconnection Devices), werden anstelle konventioneller gedruckter Schaltungen Spritzgießteile mit integrierten Leiterzügen verwendet. Hochwertige Thermoplaste, die sich zum Spritzgießen von dreidimensionalen Substraten eignen, sind die Basis dieser Technologie. Derartige Thermoplaste zeichnen sich gegenüber herkömmlichen Substratmaterialien für gedruckte Schaltungen durch bessere mechanische, thermische, chemische, elektrische und umwelttechnische Eigenschaften aus. Bei einer speziellen Richtung der MID Technologie, der sogenannten SIL-Technik (SIL = Spritzgießteile mit integrierten Leiterzügen), erfolgt die Strukturierung einer auf die Spritzgießteile aufgebrachten Metallschicht unter Verzicht auf die sonst übliche Maskentechnik durch ein spezielles Laserstrukturierungsverfahren. In die dreidimensionalen Spritzgießteile mit strukturierter Metallisierung sind dabei mehrere mechanische und elektrische Funktionen integrierbar. Die Gehäuseträgerfunktion übernimmt gleichzeitig Führungen und Schnappverbindungen, während die Metallisierungsschicht neben der Verdrahtungs- und Verbindungsfunktion auch als elektromagnetische Abschirmung dient und für eine gute Wärmeabfuhr sorgt. Weitere Einzelheiten zur Herstellung von dreidimensionalen Spritzgießteilen mit integrierten Leiterzügen, gehen beispielsweise aus der DE-A-37 32 249 oder der EP-A-0 361 192 hervor.

Aus der US-A-5 081 520 ist ein Verfahren zum Befestigen von IC-Chips auf Substraten bekannt, bei welchem die Substrate als Spritzgießteile mit integrierten Höckern für die Befestigung der IC-Chips hergestellt werden. Nach dem Metallisieren der Höcker wird eine Verbindungsschicht aufgebracht, so dass die IC-Chips auf den Substraten befestigt werden können, wobei die Chip-Anschlussflächen mit den zugeordneten Metallisierungen der Höcker elektrisch leitend verbunden werden.

Aus der WO-A-89/00346 ist eine Trägeranordnung für IC-Chips bekannt, bei welcher das spritzgegossene Substrat auf seiner Unterseite beim Spritzgießen mitgeformte Höcker trägt. Auf der Oberseite des Substrats ist ein IC-Chip angeordnet, dessen Anschlüsse über Bonddrähte mit auf der Oberseite des Substrats ausgebildeten Leiterbahnen verbunden sind.

In der internationalen Anmeldung Nr. PCT/EP95/03763 (WO-A-96/09646) wurde ein sogenanntes Polymer Stud Grid Array (PSGA) vorgeschlagen, welches die Vorteile eines Ball Grid Arrays (BGA) mit den Vorteilen der MID Technologie vereinigt. Die Bezeichnung der neuen Bauform als Polymer Stud Grid Array (PSGA) erfolgte dabei in Anlehnung an das Ball Grid Array (BGA), wobei der Begriff "Polymer Stud" auf beim Spritzgießen des Substrats mitgeformte Polymerhöcker hinweisen soll. Die neue für Single-, Few- oder Multi-Chip-Module geeignete Bauform umfasst
- ein spritzgegossenes, dreidimensionales Substrat aus einem elektrisch isolierenden Polymer,
- auf der Unterseite des Substrats flächig angeordnete und beim Spritzgießen mitgeformte Polymerhöcker,
- auf den Polymerhöckern durch eine lötbare Endoberfläche gebildete Außenanschlüsse,
- zumindest auf der Unterseite des Substrats ausgebildete Leiterzüge, die die Außenanschlüsse mit Innenanschlüssen verbinden, und
- mindestens einen auf dem Substrat angeordneten Chip, dessen Anschlüsse mit den Innenanschlüssen elektrisch leitend verbunden sind.

Neben der einfachen und kostengünstigen Herstellung der Polymerhöcker beim Spritzgießen des Substrats, kann auch die Herstellung der Außenanschlüsse auf den Polymerhöckern mit minimalem Aufwand zusammen mit der bei der MID Technologie bzw. der SIL-Technik üblichen Herstellung der Leiterzüge vorgenommen werden. Durch die bei der SIL-Technik bevorzugte Laserfeinstrukturierung, können die Außenanschlüsse auf den Polymerhöckern mit hohen Anschlußzahlen in einem sehr feinen Raster realisiert werden. Hervorzuheben ist ferner, daß die Temperaturausdehnung der Polymerhöcker den Temperaturausdehnungen des Substrats und der das Modul aufnehmenden Leiterplatte entspricht. Sollten mechanische Spannungen auftreten, so ermöglichen die Polymerhöcker durch ihre elastischen Eigenschaften zumindest einen teiilweisen Ausgleich. Durch die Formstabilität der auf den Polymerhöckern gebildeten Außenanschlüsse, kann auch die Sicherheit bei Reparatur und Austausch gegenüber den Ball Grid Arrays mit ihren durch Lothökker gebildeten Außenanschlüssen erheblich gesteigert werden.

Der im Anspruch 1 angegebenen Erfindung liegt das Problem zugrunde, eine Polymer Stud Grid Array zu schaffen, das für Mikrowellen-Schaltungsanordnungen geeignet ist.

Der Erfindung liegt die Erkenntnis zugrunde, daß Polymer Stud Grid Arrays auch für Mikrowellen-Schaltungsanordnungen geeignet sind, da die hierzu erforderlichen Streifenleitungen mit geringem zusätzlichen Aufwand auf der Unterseite des Substrats erzeugt werden können.

Gemäß Anspruch 2 können die Streifenleitungen durch eine zweite Dielektrikumsschicht abgedeckt werden, welche beim Löten einen Schutz als eine Art Lötstop-Abdeckung ermöglicht.

Ein Ausführungsbeispiel der Erfindung ist in der Zeichnung dargestellt und wird im folgenden näher beschrieben.

Es zeigen
- Figur 1: einen Schnitt durch einen Teil eines Polymer Stud Grid Arrays mit einem in Drahtbond-Technik kontaktierten Mikrowellen-Schaltkreis und
- Figur 2: einen Querschnitt durch eine Streifenleitung des in Figur 1 dargestellten Polymer Stud Grid Arrays.

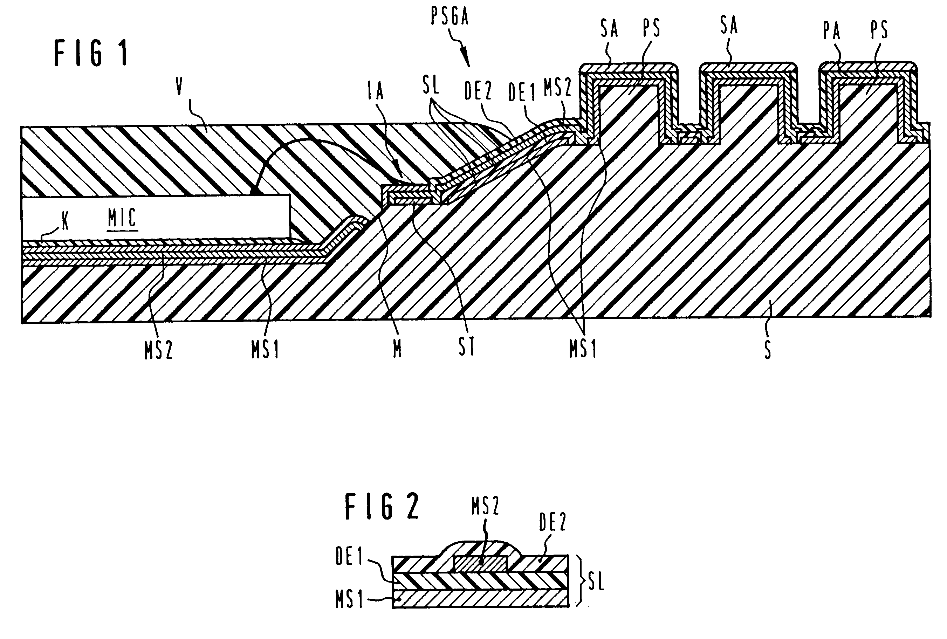

Figur 1 zeigt in stark vereinfachter schematischer Darstellung einen Schnitt durch einen Teil eines Polymer Stud Grid Arrays PSGA mit einem in Drahtbond-Technik kontaktierten integrierten Mikrowellenschaltkreis MIC. Basis des dargestellten Arrays ist ein Substrat S, das mit "Polymer Studs" bzw. Polymerhöckern PS und einer Mulde M versehen ist, wobei die Mulde M eine mit ST bezeichnete Stufe aufweist. Die Herstellung des Substrats S einschließlich Polymerhöckern PS, Mulde M und Stufe ST, erfolgt durch Spritzgießen, wobei als Substratmaterialien hochtemperaturbeständige Thermoplaste, wie z.B. Polehteremid geeignet sind.

Im Bereich des Bodens der Mulde M sind auf das Substrat S nacheinander eine erste Metallschicht MS1, eine zweite Metallschicht MS2 und eine lötbare Endoberfläche E aufgebracht, wobei die beiden Metallschichten MS1 und MS2 beispielsweise aus Kupfer bestehen, und wobei die lötbare Endoberfläche E beispielsweise durch eine Schichtenfolge aus Nickel und Gold gebildet ist. Auf der Endoberfläche E ist der integrierte Mikrowellenschaltkreis MIC in Face up-Lage mit Hilfe eines elektrisch leitenden Klebers K befestigt. Die nicht näher bezeichnete Anschlüsse des Mikrowellenschaltkreises MIC sind über Kontaktierdrähte KD mit auf der Stufe ST angeordneten Innenanschlüssen IA verbunden.

Auf die Polymerhöcker PS ist die vorstehend erwähnte Schichtenfolge aus erster Metallschicht MS1, zweiter Metallschicht MS2 und lötbarer Endoberfläche E ebenfalls aufgebracht. Die lötbare Endoberfläche E bildet dabei bei mindestens einem Polymerhöcker PS einen Potentialanschluß PA und bei den anderen Polymerhöckern PS Signalanschlüsse SA. Im Bereich des insbesondere als Masseanschluß dienenden Potentialanschlusses PA ist die zweite Metallschicht MS2 durch mittels Laserstrukturierung hergestellte Gräben von den übrigen Bereichen der zweiten Metallschicht MS2 elektrisch getrennt. Im Bereich der Signalanschlüsse SA ist die erste Metallschicht MS1 durch mittels Laserstrukturierung hergestellte Gräben von den übrigen Bereichen der ersten Metallschicht MS1 und insbesondere von dem Potentialanschluß PA elektrisch getrennt.

Auf der Unterseite des Substrats S sind insgesamt mit SL bezeichnete Streifenleitungen ausgebildet, die durch die erste strukturierte Metallschicht MS1, eine hier aufgebrachte erste Dielektrikumsschicht DE1, die zweite strukturierte Metallschicht MS2 und eine zweite Dielektrikumsschicht DE2 gebildet sind. Die in Figur 2 im Querschnitt dargestellten Streifenleitungen SL stellen Leitungen mit einer kontrollierten Impedanz dar, die durch die Geometrie der einzelnen Bestandteile und insbesondere durch die Breite der Metallschichten MS1 und MS2 und durch die Stärke der ersten Dielektrikumsschicht DE1 bestimmt wird.

Die als Streifenleiter der Streifenleitungen SL dienenden Bahnen der zweiten Metallschicht MS2 verbinden die Signalanschlüsse SA mit den zugeordneten Innenanschlüssen IA.

Durch Füllen der Mulde M mit Kunststoff ist eine Verkapselung V für den integrierten Mikrowellenschaltkreis MIC gebildet, wobei die Verkapselung V gleichzeitig auch einen mechanischen Schutz für die Kontaktierdrähte KD bildet.

## Patentansprüche

1. Polymer Stud Grid Array für Mikrowellen-Schaltungsanordnungen, mit
- einem spritzgegossenen, dreidimensionalen Substrat (S) aus einem elektrisch isolierenden Polymer,
- auf der Unterseite des Substrats (S) flächig angeordneten und beim Spritzgießen mitgeformten Polymerhöckern (PS),
- auf mehreren Polymerhöckern (PS) durch eine lötbare Endoberfläche gebildeten Signalanschlüssen (SA),
- auf mindestens einem Polymerhöcker (PS) durch eine lötbare Endoberfläche gebildeten Potentialanschluß (PA),
- auf der Unterseite des Substrats (S) ausgebildeten Streifenleitungen (SL), die durch eine erste strukturierte Metallschicht (MS1), eine Dielektrikumsschicht (DE1) und eine zweite strukturierte Metallschicht (MS2) gebildet sind, wobei die erste strukturierte Metallschicht (MS1) mit dem Potentialanschluß (PA) elektrisch leitend verbunden ist, und wobei die zweite strukturierte Metallschicht (MS2) der Streifenleitungen (SL) die Signalanschlüsse (SA) mit zugeordneten Innenanschlüssen (IA) verbinden, und mit
- mindestens einem auf dem Substrat (S) angeordneten, integrierten Mikrowellenschaltkreis (MIC), dessen Anschlüsse mit den Innenanschlüssen (IA) elektrisch leitend verbunden sind.

2. Polymer Stud Grid Array nach Anspruch 1,
**dadurch gekennzeichnet,**
**daß** auf die zweite strukturierte Metallschicht (MS2) im Bereich der Streifenleitungen (SL) eine zweite Dielektrikumsschicht (DE2) aufgebracht ist.

## Claims

1. Polymer stud grid array for microwave circuit arrangements, having
- an injection-moulded, three-dimensional substrate (S) composed of an electrically insulating polymer,
- polymer studs (PS) which are arranged over the area on the underneath of the substrate (S) and are integrally formed during injection moulding,
- signal connections (SA) formed on a plurality of polymer studs (PS) by means of an end surface which can be soldered,
- a potential connection (PA) formed on at least one polymer stud (PS) by an end surface which can be soldered,
- striplines (SL) which are constructed on the underneath of the substrate (S) and are formed by a first structured metal layer (MS1), a dielectric layer (DE1) and a second structured metal layer (MS2), the first structured metal layer (MS1) being electrically conductively connected to the potential connection (PA), and the second structured metal layer (MS2) of the striplines (SL) connecting the signal connections (SA) to associated internal connections (IA), and having
- at least one integrated microwave circuit (MIC) which is arranged on the substrate (S) and whose connections are electrically conductively connected to the internal connections (IA).

2. Polymer stud grid array according to Claim 1, **characterized in that**
a second dielectric layer (DE2) is applied to the second structured metal layer (MS2) in the region of the striplines (SL).

## Revendications

1. Polymère Stud Grid Array pour des circuits micro-ondes, comprenant
- un substrat (S) moulé par injection en trois dimensions et constitué d'un polymère isolant du point de vue électrique,
- des bossages (PS) en polymère disposés à plat sur la face inférieure du substrat (S) et formés en même temps lors du moulage par injection,
- des bornes (SA) de signal formées sur plusieurs bossages (PS) en polymère par une surface d'extrémité pouvant être brasée,
- une borne (PA) de potentiel formée sur au moins un bossage (PS) de polymère par une surface d'extrémité pouvant être brasée,
- des conducteurs (SL) à ruban constitués sur la face inférieure du substrat (S) et formés par une première couche (MS1) structurée de métal, une couche (DE1) de diélectrique et une deuxième couche (MS2) structurée de métal, la première couche (MS1) structurée de métal étant reliée d'une manière conductrice de l'électricité à la borne (PA) de potentiel et la deuxième couche (MS2) structurée de métal des conducteurs (SL) à ruban reliant les bornes (SA) de signal aux bomes (lA) intérieures associées et
- au moins un circuit (MIC) intégré à micro-ondes disposé sur le substrat et dont les bornes sont reliées d'une manière conductrice de l'électricité aux bornes (lA) intérieures.

2. Polymère Stud Grid Array suivant la revendication 1,
**caractérisé en ce qu'**il est déposé sur la deuxième couche (MS2) structurée de métal dans la région des conducteurs (SL) à ruban une deuxième couche (DE2) de diélectrique.
